# EUROPÄISCHE PATENTSCHRIFT

(11) **EP 1 804 065 B1**
(45) Veröffentlichungstag und Bekanntmachung des Hinweises auf die Patenterteilung: **13.04.2016**
(21) Anmeldenummer: 06026126.0
(22) Anmeldetag: 16.12.2006
(51) Int. Cl.: H02B 1/03, G01R 22/06

(54) **Zählerplatz**
Mounting platform for utility meter
Montage pour un compteur de service

(30) Priorität: 31.12.2005 DE 102005063203
(43) Veröffentlichungstag der Anmeldung: 04.07.2007
(73) Patentinhaber: ABB AG, 68309 Mannheim (DE)
(72) Erfinder: Roth, Michael, 77880 Sasbach (DE)

(56) Entgegenhaltungen:
- DE-A1-102004 022 785
- DE-A1-102004 049 799
- DE-U1- 20 206 995
- US-A- 2 403 132
- US-A1- 2005 282 431

## Beschreibung

Die Erfindung betrifft eine Verteilervorrichtung zur Verteilung und Leitung von elektrischer Energie beziehungsweise elektrischem Strom gemäß Anspruch 1.

Bekannte Verteilervorrichtungen bedingen in aller Regel eine vergleichsweise aufwendige Montage von Verteiler- und/oder Zählerkomponenten in dafür individuell eingerichteten Montagerahmen, wobei die Befestigung vorgenanter Komponenten vornehmlich durch Verschraubungen mit dem jeweiligen Rahmen erfolgt. Demgemäß gestaltet sich auch der Austausch vorgenannter Komponenten vergleichsweise aufwendig, da zunächst die vorgenannten Verbindungen gelöst werden müssen. Auch eine Erweiterung, um beispielsweise einen weiteren Zähler, gestaltet sich vergleichsweise aufwendig, da in aller Regel auch der entsprechende Montagerahmen zu wechseln beziehungsweise zu erweitern ist.

Eine derartige Verteilervorrichtung ist aus dem DE20206995U1 und aus dem DE 10 2004 022785 bekannt geworden, die eine Zählereinrichtung beschreibt, die eine Zählertragplatte aufweist, auf der auch mehrere Installationsfelder für die Aufnahme von Zählertragplattenkomponenten vorgesehen sind. Derartige Zählertragplattenkomponenten können beispielsweise Leitungsschutzschalter und dergleichen sein.

Aus der US2005/282431A1 ist ein Adapter bekannt geworden, der aus einem oberen und unteren Abschnitt 38,36 zusammengesetzt ist, welche beiden Abschnitte miteinander verbunden sind. Zwischen zwei Armen am oberen Abschnitt ist ein Träger einsetzbar, der Führungsvorsprünge aufweist, in die ein daran angepasster Zähler einsetzbar ist.

Auch bei diesem Adapter gestaltet sich der Austausch von Zählerkomponenten insbesondere des Zählers, vergleichsweise aufwändig, da zunächst die Verbindungen zwischen den oberen und unteren Abschnitt gelöst werden müssen. Eine Erweiterung um einen weiteren Zähler ist bei dieser Anordnung nicht ohne weiteres möglich.

Aufgabe der Erfindung ist es, eine hinsichtlich der Montage von Zählerkomponenten verbesserte Verteilervorrichtung zur Verteilung und Leitung von elektrischer Energie und/oder elektrischem Strom anzugeben

Diese Aufgabe wird durch eine Verteilervorrichtung mit den Merkmalen des Anspruch 1 gelöst. Vorteilhafte Ausgestaltungen und Weiterbildungen der Erfindung sind in den abhängigen Ansprüchen und der nachfolgenden Beschreibung angegeben.

Die erfindungsgemäße Verteilervorrichtung zur Weiterleitung und/oder Verteilung elektrischer Energie und/oder elektrischem Strom umfasst wenigstens eine Zählerkomponente und zumindest zwei Tragschienen, an welchen die wenigstens eine Zählerkomponente befestigt ist. Die beiden Tragschienen sind im Bereich der wenigstens einen Zählerkomponente durch eine Montageplatte verbunden. An der Montageplatte ist zumindest eine Kontaktplatte angeordnet und/oder angebracht, an der die wenigstens eine Zählerkomponente befestigt ist.

In einer vorteilhaften Weiterbildung umfasst die wenigstens eine Zählerkomponente wenigstens einen elektronischen Stromzähler.

In einer weiteren vorteilhaften Ausgestaltung ist eine Zählerplatte vorgesehen, welche an den Tragschienen befestigt ist und wenigstens eine Montageöffnung aufweist, durch die die wenigstens eine Zählerkomponente durchgreift.
Des Weiteren ist neben der wenigstens einen Montageöffnung eine mit einem Zählerplattenabschnitt verschlossene, weitere Montageöffnung vorsehbar.

In einer weiteren Ausgestaltung der Verteilervorrichtung ist der Zählerplattenabschnitt lösbar angeordnet und/oder entfernbar.

Auch kann die Zählerplatte rechteckig ausgebildet sein und/oder an wenigstens zwei Ecken des Rechtecks jeweils an einer der beiden Tragschienen befestigt sein.

In Weiterbildung der Verteilervorrichtung ist vorsehbar, dass an den beiden Tragschienen noch weitere Verteilerkomponenten und/oder Zählerkomponenten befestigbar sind.

In einer weiteren Fortbildung der Verteilervorrichtung ist vorgesehen, dass die zumindest eine Kontaktplatte die tragende Funktion für die wenigstens eine Zählerkomponente besitzt.

Weiterhin ist vorteilhaft vorsehbar, dass die Montageplatte wenigstens eine Ausnehmung aufweist durch welche die wenigstens eine Kontaktplatte an der Montageplatte befestigt ist.

In vorteilhafter Weiterbildung ist die zumindest eine Kontaktplatte als Kontaktgehäuse zur Aufnahme von Kontakt- und/oder Leiterelementen ausgebildet.

In einer vorteilhaften Ausgestaltung der Verteilervorrichtung weist die wenigstens eine Zählerkomponente zwei benachbarte elektronische Stromzähler auf.

Eine Vorrichtung, in der mehrere Stromzähler vorgesehen sind, ist an sich aus der US2403132 bekannt geworden.

Die weitere Darlegung der Erfindung sowie vorteilhafter Ausgestaltungen und Weiterbildungen erfolgt anhand einiger Figuren und Ausführungsbeispiele.

Es zeigen
Fig. 1 beispielhaft ausgebildete Verteilervorrichtung mit einem elektronischen Stromzähler in Explosionsdarstellung,
Fig. 2 beispielhaft ausgebildete Verteilervorrichtung mit zwei elektronischen Stromzählern und
Fig. 3 beispielhaft ausgebildete Verteilervorrichtung mit zwei elektronischen Stromzählern in Explosionsdarstellung.

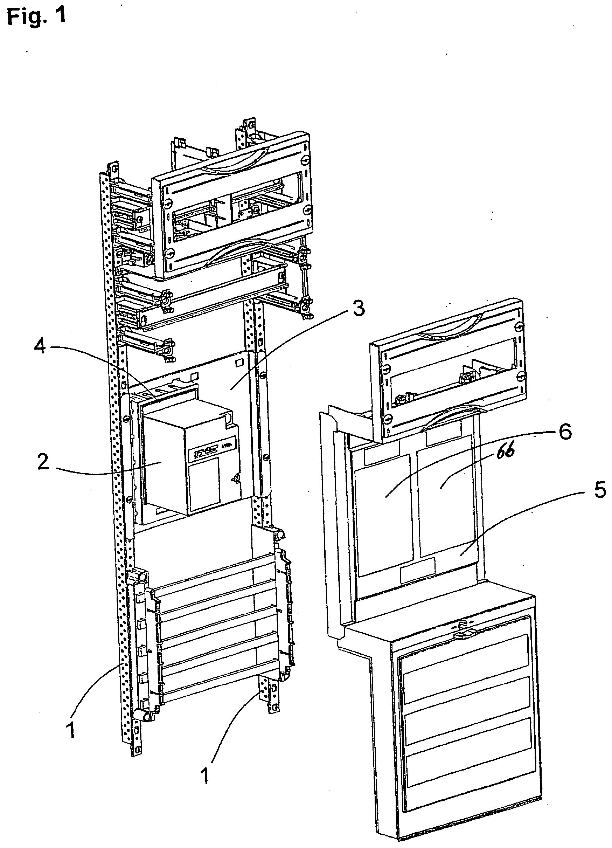

In Fig. 1 ist in Explosionsdarstellung eine Verteilervorrichtung zur Weiterleitung und/oder Verteilung elektrischer Energie und/oder elektrischem Strom mit einer beispielhaft als elektronischer Stromzähler ausgebildeten Zählerkomponenten (2) und zwei Tragschienen (1) gezeigt, an welchen der elektronische Stromzähler (2) befestigt ist. Die beiden Tragschienen (1) sind im Bereich der Zählerkomponente (2) durch eine Montageplatte (3) verbunden, welche an den Tragschienen insbesondere durch Verschraubung befestigt ist. An der Montageplatte ist eine Kontaktplatte (4) angebracht, an der die wenigstens eine Zählerkomponente (2) befestigt ist.

Die Kontaktplatte (4) übernimmt dabei die tragende Funktion für die Zählerkomponente (2) weist mehrere Ausnehmung und/oder Anformungen auf, durch welche die wenigstens eine Kontaktplatte (4) an der Montageplatte (3) befestigt ist. Die Befestigung erfolgt dabei über Verrastung und/oder Verschraubung und/oder Klemmung, wobei Kontaktplatte (4) und Montageplatte (3) jeweils korrespondierende Befestigungsmittel aufweisen.

Des Weiteren ist eine Zählerplatte (5) vorgesehen, welche an den Tragschienen (1) befestigt ist und wenigstens eine Montageöffnung (6) aufweist, durch die die wenigstens eine Zählerkomponente (2) durchgreift.

Weiterhin ist neben der einen Montageöffnung (6) eine mit einem Zählerplattenabschnitt verschlossene, weitere Montageöffnung (6b) zum Durchgriff eines weiteren Stromzählers und/oder einer weiteren Zählerkomponente (2) vorgesehen. Der Zählerplattenabschnitt ist dabei lösbar angeordnet und/oder entfernbar, beispielsweise durch Verschraubung und/oder Verrastung und/oder Klemmung, wobei der Zählerplattenabschnitt und die Zählerplatte jeweils korrespondierende Befestigungsmittel aufweisen.

Auch kann die Zählerplatte rechteckig ausgebildet sein und/oder an wenigstens zwei Ecken des Rechtecks jeweils an einer der beiden Tragschienen befestigt sein.

In Weiterbildung der Verteilervorrichtung ist vorsehbar, dass an den beiden Tragschienen noch weitere Verteilerkomponenten und/oder Zählerkomponenten befestigbar sind.

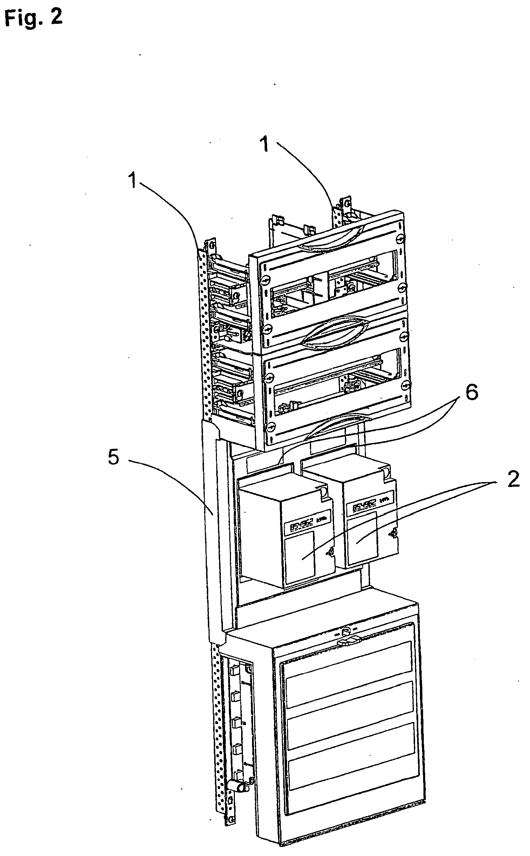

In Fig. 2 ist eine Verteilervorrichtung zur Weiterleitung und/oder Verteilung elektrischer Energie und/oder elektrischem Strom mit einer Zählerkomponente (2) mit zwei elektronischer Stromzählern (2) und zwei Tragschienen (1) gezeigt, an welchen die elektronischen Stromzähler (2) befestigt sind. Die beiden Tragschienen (1) sind im Bereich der Zählerkomponente (2) durch eine Montageplatte (3) verbunden, welche an den Tragschienen durch Verschraubung befestigt ist. An der Montageplatte (3) ist eine Kontaktplatte (nicht explizit dargestellt) angebracht, an der die Zählerkomponente (2) befestigt ist.

Für jeden Stromzähler ist dabei alternativ auch jeweils eine eigene Kontaktplatte vorsehbar.

Die elektronischen Stromzähler der Zählerkomponente (2) sind dabei benachbart angeordnet.

Des Weiteren ist eine Zählerplatte (5) vorgesehen, welche an den Tragschienen (1) befestigt ist und zwei Montageöffnungen (6) aufweist, durch die die beiden Stromzähler der Zählerkomponente (2) durchgreifen. Die Befestigung erfolgt dabei beispielsweise durch Verschraubung und/oder Verrastung und/oder Klemmung, wobei Zählerplatte (5) und Tragschiene (1) jeweils korrespondierende Befestigungsmittel aufweisen.

Auch kann die Zählerplatte (5) rechteckig ausgebildet sein und/oder an wenigstens zwei Ecken des Rechtecks jeweils an einer der beiden Tragschienen (1) befestigt sein.

Darüber hinaus weisen die beiden Tragschienen noch weitere Befestigungsmittel wie beispielsweise Ausnehmungen und/oder Gewindebohrungen zur Aufnahme und/oder Befestigung weiterer Verteilerkomponenten und/oder Zählerkomponenten auf.

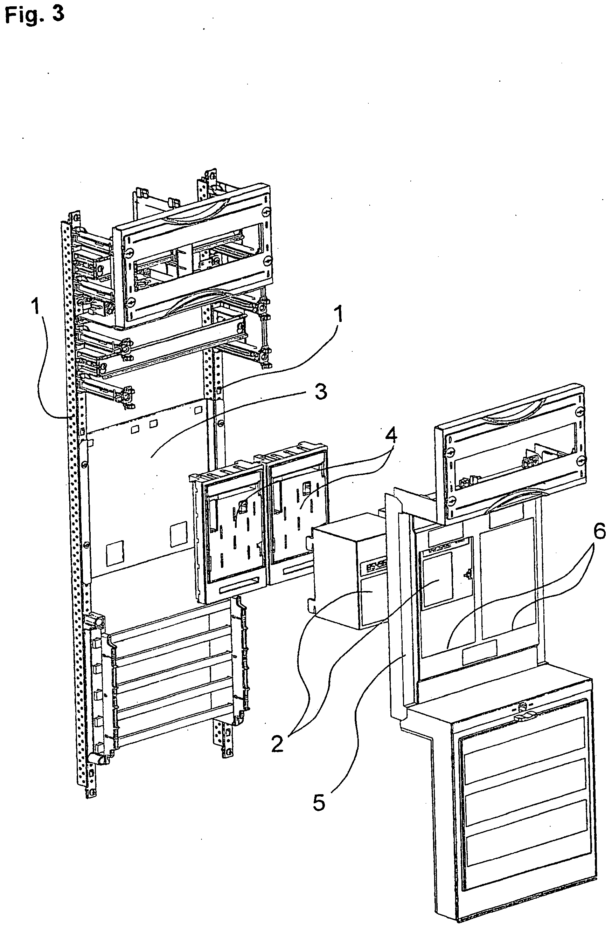

In Fig. 3 ist in Explosionsdarstellung eine Verteilervorrichtung zur Weiterleitung und/oder Verteilung elektrischer Energie und/oder elektrischem Strom mit einer Zählerkomponente (2) mit zwei elektronischer Stromzählern (2) und zwei Tragschienen (1) gezeigt, an welchen die elektronischen Stromzähler (2) befestigt sind. Die beiden Tragschienen (1) sind im Bereich der Zählerkomponente (2) durch eine Montageplatte (3) verbunden, welche an den Tragschienen durch Verschraubung befestigt ist. An der Montageplatte (3) ist für jeden Stromzähler jeweils eine eigene Kontaktplatte (4) vorgesehen. Die Kontaktplatten (4) sind dabei vorteilhaft als Kontaktgehäuse zur Aufnahme von Kontaktelementen und/oder Leiterelementen ausgebildet.

Die elektronischen Stromzähler der Zählerkomponente (2) sind dabei benachbart angeordnet.

Die Kontaktplatte (4) übernimmt dabei die tragende Funktion für den jeweiligen Stromzähler (2) und weist mehrere Ausnehmung und/oder Anformungen auf, durch welche die wenigstens eine Kontaktplatte (4) an der Montageplatte (3) befestigt ist. Die Befestigung erfolgt dabei insbesondere über Verrastung und/oder Verschraubung und/oder Klemmung, wobei Kontaktplatte (4) und Montageplatte (3) jeweils korrespondierende Befestigungsmittel aufweisen.

Des Weiteren ist eine Zählerplatte (5) vorgesehen, welche an den Tragschienen (1) befestigt ist und zwei Montageöffnungen (6) aufweist, durch die die beiden Stromzähler der Zählerkomponente (2) durchgreifen. Die Befestigung erfolgt dabei beispielsweise durch Verschraubung und/oder Verrastung und/oder Klemmung, wobei Zählerplatte (5) und Tragschiene (1) jeweils korrespondierende Befestigungsmittel aufweisen. Zur Klemmung kann dabei in der Zählerplatte (5) wenigstens eine entsprechende Nut vorgesehen sein in die jeweils eine der Tragschienen eingreift und/oder geklemmt ist.

Auch kann die Zählerplatte (5) rechteckig ausgebildet sein und/oder an wenigstens zwei Ecken des Rechtecks jeweils an einer der beiden Tragschienen (1) befestigt sein.

Darüber hinaus weisen die beiden Tragschienen noch weitere Befestigungsmittel wie beispielsweise Ausnehmungen und/oder Gewindebohrungen zur Aufnahme und/oder Befestigung weiterer Verteilerkomponenten und/oder Zählerkomponenten auf.

## Patentansprüche

1. Verteilervorrichtung zur Weiterleitung und/oder Verteilung elektrischer Energie und/oder elektrischen Stromes mit wenigstens einer Zählerkomponente (2) und mit einer Montageplatte (3), an den die wenigsten eine Zählerkomponente angebracht ist, **dadurch gekennzeichnet, dass** zwei parallel verlaufenden Tragschienen (1) durch die Montageplatte (3) verbunden sind, an welcher Montageplatte (3) zumindest eine Kontaktplatte (4) angebracht ist, an der die wenigstens eine Zählerkomponente (2) befestigt ist und welche die tragende Funktion für die wenigstens eine Zählerkomponente (2) aufweist, wobei eine Zählerplatte (5) vorgesehen ist, welche an den Tragschienen (1) befestigt ist und wenigstens eine Montageöffnung (6) aufweist, durch die die wenigstens eine Zählerkomponente (2) durchgreift.

2. Verteilervorrichtung nach Anspruch 1, **dadurch gekennzeichnet**, das die wenigstens eine Zählerkomponente (2) ein elektronischer Stromzähler ist.

3. Verteilervorrichtung nach Anspruch 2, **dadurch gekennzeichnet, dass** neben der wenigstens einen Montageöffnung (6) eine mit einem Zählerplattenabschnitt verschlossene weitere Montageöffnung (6b) vorgesehen ist.

4. Verteilervorrichtung nach Anspruch 3, **dadurch gekennzeichnet, dass** der Zählerplattenabschnitt lösbar angeordnet und/oder entfernbar ist.

5. Verteilervorrichtung nach einem der Ansprüche 1 bis 4, **dadurch gekennzeichnet, dass** die Zählerplatte (5) rechteckig ausgebildet ist und/oder an wenigstens zwei Ecken des Rechtecks jeweils an einer der beiden Tragschienen (1) befestigt ist.

6. Verteilervorrichtung nach einem der vorherigen Ansprüche, **dadurch gekennzeichnet, dass** an den beiden Tragschienen (1) noch weitere Verteilerkomponenten und/oder Zählerkomponenten befestigbar sind.

7. Verteilervorrichtung nach einem der vorherigen Ansprüche, **dadurch gekennzeichnet, dass** die Montageplatte (3) wenigstens eine Ausnehmung aufweist durch welche die wenigstens eine Kontaktplatte (4) an der Montageplatte (3) befestigbar ist.

8. Verteilervorrichtung nach einem der vorherigen Ansprüche, **dadurch gekennzeichnet, dass** die zumindest eine Kontaktplatte (4) als Kontaktgehäuse zur Aufnahme von Kontakt- und/oder Leiterelementen ausgebildet ist.

9. Verteilervorrichtung nach einem der vorherigen Ansprüche, **dadurch gekennzeichnet, dass** die zumindest eine Kontaktplatte (4) die tragende Funktion für die wenigstens eine Zählerkomponente (2) besitzt.

10. Verteilervorrichtung nach einem der vorherigen Ansprüche, **dadurch gekennzeichnet, dass** als wenigstens eine Zählerkomponente (2) zwei benachbarte elektronische Stromzähler vorgesehen sind.

## Claims

1. Distributor apparatus for forwarding and/or distributing electrical energy and/or electric current, having at least one meter component (2) and having a mounting board (3) to which the at least one meter component is fitted, **characterized in that** two supporting rails (1) which run in parallel are connected by the mounting board (3), at least one contact plate (4) to which the at least one meter component (2) is fastened and which has the supporting function for the at least one meter component (2) is fitted to the said mounting board (3), wherein a meter board (5) which is fastened to the supporting rails (1) and has at least one mounting opening (6), through which the at least one meter component (2) passes, is provided.

2. Distributor apparatus according to Claim 1, **characterized in that** the at least one meter component (2) is an electronic electricity meter.

3. Distributor apparatus according to Claim 2, **characterized in that**, in addition to the at least one mounting opening (6), a further mounting opening (6b) which is closed by a meter board section is provided.

4. Distributor apparatus according to Claim 3, **characterized in that** the meter board section is arranged in a detachable manner and/or can be removed.

5. Distributor apparatus according to one of Claims 1 to 4, **characterized in that** the meter board (5) is rectangular and/or is fastened to in each case one of the two supporting rails (1) at at least two corners of the rectangle.

6. Distributor apparatus according to one of the preceding claims, **characterized in that** yet further distributor components and/or meter components can be fastened to the two supporting rails (1).

7. Distributor apparatus according to one of the preceding claims, **characterized in that** the mounting board (3) has at least one recess through which the at least one contact plate (4) can be fastened to the mounting board (3).

8. Distributor apparatus according to one of the preceding claims, **characterized in that** the at least one contact plate (4) is in the form of a contact housing for accommodating contact and/or conductor elements.

9. Distributor apparatus according to one of the preceding claims, **characterized in that** the at least one contact plate (4) has the supporting function for the at least one meter component (2).

10. Distributor apparatus according to one of the preceding claims, **characterized in that** two adjacent electronic electricity meters are provided as at least one meter component (2).

## Revendications

1. Dispositif de distribution destiné à transférer et/ou distribuer de l'énergie électrique et/ou du courant électrique, comprenant au moins un composant compteur (2) et comprenant une plaque de montage (3) sur laquelle est monté l'au moins un composant compteur **caractérisé en ce que** deux rails porteurs (1) qui s'étendent en parallèle sont reliés par la plaque de montage (3), plaque de montage (3) sur laquelle est montée au moins une plaque de contact (4) à laquelle est fixé l'au moins un composant compteur (2) et laquelle possède la fonction porteuse pour l'au moins un composant compteur (2), une plaque de compteur (5) étant présente, laquelle est fixée aux rails porteurs (1) et possède au moins une ouverture de montage (6) à travers laquelle vient en prise l'au moins un composant compteur (2).

2. Dispositif de distribution selon la revendication 1, **caractérisé en ce que** l'au moins un composant compteur (2) est un compteur d'électricité électronique.

3. Dispositif de distribution selon la revendication 2, **caractérisé en ce qu'**une ouverture de montage supplémentaire (6b) fermée avec une portion de plaque de compteur se trouve à côté de l'au moins une ouverture de montage (6).

4. Dispositif de distribution selon la revendication 3, **caractérisé en ce que** la portion de plaque de compteur est disposée de manière amovible et/ou peut être retirée.

5. Dispositif de distribution selon l'une des revendications 1 à 4, **caractérisé en ce que** la plaque de compteur (5) est de configuration rectangulaire et/ou est respectivement fixée à l'un des deux rails porteurs (1) à au moins deux coins du rectangle.

6. Dispositif de distribution selon l'une des revendications précédentes, **caractérisé en ce que** des composants distributeurs et/ou des composants compteurs supplémentaires peuvent encore être fixés aux deux rails porteurs (1).

7. Dispositif de distribution selon l'une des revendications précédentes, **caractérisé en ce que** la plaque de montage (3) possède au moins une cavité à travers laquelle l'au moins une plaque de contact (4) peut être fixée à la plaque de montage (3).

8. Dispositif de distribution selon l'une des revendications précédentes, **caractérisé en ce que** l'au moins une plaque de contact (4) est réalisée sous la forme d'un boîtier de contact destiné à accueillir des éléments de contact et/ou conducteurs.

9. Dispositif de distribution selon l'une des revendications précédentes, **caractérisé en ce que** l'au moins une plaque de contact (4) possède la fonction porteuse pour l'au moins un composant compteur (2).

10. Dispositif de distribution selon l'une des revendications précédentes, **caractérisé en ce que** deux compteurs d'électricité électroniques voisins sont prévus en tant qu'au moins un composant compteur (2).
